(19) Europäisches Patentamt
European Patent Office
Office européen des brevets

(11) **EP 0 505 526 B1**

(12) **EUROPÄISCHE PATENTSCHRIFT**

(45) Veröffentlichungstag und Bekanntmachung des Hinweises auf die Patenterteilung:
**03.01.1996 Patentblatt 1996/01**

(21) Anmeldenummer: **91916052.3**

(22) Anmeldetag: **24.09.1991**

(51) Int Cl.6: **G01R 21/00**, G01R 11/64

(86) Internationale Anmeldenummer:
**PCT/AT91/00104**

(87) Internationale Veröffentlichungsnummer:
**WO 92/07276 (30.04.1992 Gazette 1992/10)**

(54) **MAXIMUMWÄCHTER, INSBESONDERE FÜR DIE TARIFBERECHNUNG**

MAXIMUM MONITOR, ESPECIALLY FOR RATE CALCULATION

CONTROLEUR DE MAXIMUM, NOTAMMENT POUR LA TARIFICATION

(84) Benannte Vertragsstaaten:
**AT BE CH DE DK ES FR GB GR IT LI LU NL SE**

(30) Priorität: **11.10.1990 AT 2052/90**

(43) Veröffentlichungstag der Anmeldung:
**30.09.1992 Patentblatt 1992/40**

(73) Patentinhaber: **Weidmüller GmbH**
**A-1220 Wien (AT)**

(72) Erfinder: **KRONBERGER, Gerhard**
**A-1220 Wien (AT)**

(74) Vertreter: **Puchberger, Peter, Dipl.-Ing. et al**
**A-1011 Wien (AT)**

(56) Entgegenhaltungen:
**DE-A- 2 305 455          DE-A- 2 405 466**
**US-A- 4 075 699**

**Beschreibung**

Die Zielgruppe für die erfindungsgemäße Vorrichtung sind jene Kunden der Elektroversorgungsunternehmen, im folgenden EVU genannt, die mit ihrem Stromlieferanten sogenannte Sondertarifverträge abgeschlossen haben.

Bei dieser Tarifart wird einerseits, wie bei allen Tarifverträgen von elektrischer Energie, die gelieferte Arbeit in Kilowattstunden erfaßt. Zugleich ermittelt ein weiterer Zähler die viertelstündliche Arbeitsleistung, genannt Maximumzähler. Diese Zählung dient einerseits zur Festlegung der monatlichen Grundgebühr, andererseits werden damit die Höhe der Anschlußleistung und somit die Kosten für die Erstellung der dafür notwendigen vorgelagerten Anlagen wie Kabel, Trafo, Leitungen, etc. eruiert.

Üblicherweise wird nicht jede Viertelstundenleistung erfaßt, sondern nur die bis zur letzten Ablesung höchste. Bei den meisten EVUs dient das Mittel der 3 höchsten Spitzen im Jahr für die jährliche Grundgebühr und für den Baukostenzuschuß als Verrechnungsgrundlage. Die Zählerablesung erfolgt jeden Monat.

Ein dritter Zähler ist noch in den meisten Fällen zur Erfassung der Blindleistung vorhanden. In Zukunft ist damit zu rechnen, daß für die Ermittlung der Viertelstundenspitze die Blindleistung, resp. der Phasenwinkel cos phi herangezogen wird.

Die Aufgabe des Maximumwächters ist es, durch Abschalten von diversen Verbrauchern die vertragliche Viertelstundenleistung einzuhalten. Maximumwächter im Bereich der taktmäßigen elektrischen Energieverbrauchsbegrenzung gibt es bereits seit längerer Zeit.

Die Verbrauchs-Messung dieser Geräte erfolgt aufgrund der Berechnung des Mittelwertes, dessen Bezugspunkte der kumulierte und der vorgegebene Meßperiodenwert sowie die abgelaufene Meßperiodendauer - standardmäßig 15 Minuten - sind. Ist dabei der kumulierte Meßperiodenwert höher als der vorgegebene, werden die einzelnen Verbrauchergruppen nacheinander, zeitmäßig verzögert, abgeschaltet. Es kann bei fast allen Herstellern eine Mindest-Einschaltzeit der abzuschaltenden Verbraucher festgelegt werden, genannt Sperrzeit. Nach Ablauf dieser Sperrzeit beginnt die zeitverzögerte Abschaltung der einzelnen Verbraucher. Die Zuschaltung aller Verbraucher erfolgt bei Unterschreitung des Mittelwertes nach Ablauf von einer vorgegebenen Zuschaltverzögerungszeit oder bei Neubeginn einer Meßperiode.

Nachteilig ist dabei, daß immer relativ große Lasten (z.B. 20 bis 100 kW) geschaltet werden müssen, da die erste und zweite Generation dieser Geräte nur 2 oder 3 Abschaltmöglichkeiten bieten. Die rein zeitliche Abschaltfolge bedingt eine hohe Abschalthäufigkeit. An vielen Anlagen ist die Maximumüberwachung wegen aufgetretener Betriebsstörung außer Funktion. Hauptproblem dieser Anlagen ist jedoch die unkontrollierte Ausschaltdauer, wenn man die Sperrzeit, die ja für alle Stufen gleich ist, außer acht läßt.

Daraus folgt, daß nur relativ unwichtige und unkritische Verbraucher angesteuert werden können.

Im Laufe der 80er Jahre kam das Integralberechnungsverfahren auf den Markt. Dabei wird wiederum der Mittelwert berechnet. Um jedoch eine leistungsbezogene Abschaltung zu erreichen, werden mehrere Mittelwerte, bis zu fünf oder sechs, als Soll-Werte übereinandergelegt. Aufgrund des Vergleiches der Soll-Werte mit dem Verbrauchs-Mittelwert (Ist-Wert) werden leistungsbezogene Abschaltpunkte errechnet.

Der Vorteil ist, daß hier nicht mehr zeitverzögert, sondern bereits leistungsbezogen, prozentmäßig vorgebbar, abgeschaltet wird. Es gibt bei diesen Geräten auch keine Sperrzeit.

Als Nachteil tritt hierbei der starre Abschaltungsablauf auf. Wohl ist bei Anlagen der neuen Generation die Stufenanzahl bereits auf 6 erhöht worden, einsetzbar sind diese Geräte weiterhin nur bei Kleinanlagen zur Einbeziehung von unwichtigen und unkritischen Verbrauchern in den Abschaltzyklus.

Mitte der 80er Jahre wurde dann die Mehrfach-Mittelwert- oder Mehrfach-Tendenzberechnung entwickelt. Dabei werden die in die Abschaltung einbezogenen Verbraucher nach ihrem Wert erfaßt, z.B. 5 in der Grundausstattung, maximal 37 in der höchsten Ausbaustufe. Der vorgegebene Sollwert bildet dabei den Mittelwert (Tendenz, Trend), der für die Berechnung der zulässigen Überschreitung mit dem nächsten Verbraucherwert einen neuen Mittelwert bildet. Es wird zusätzlich die maximale Abschaltdauer des Verbrauchers berücksichtigt. Ist dieser neue Mittelwert erreicht, wird der neue Mittelwert mittels der Wertigkeit des nächstprogrammierten Verbrauchers gebildet.

Als Nachteil ergab sich dabei, daß die Geräte nur für wenige Verbraucher ausgelegt waren. Dies bedeutet wiederum eine Zusammenlegung mehrerer Lasten und damit relativ große Abschaltblöcke. Der eingesetzte Zeitschaltcomputer umfaßte fixe Zeitblöcke , auf die die einzelnen Verbraucher zugreifen konnten.Es ist somit keine individuelle Zeitschaltung für jeden der maximal 37 Verbraucher möglich gewesen. Zuschaltungen nur unter der Berücksichtigung freier Leistung waren nicht möglich. (z.B. Boiler tagsüber zuzuschalten ist nur dann sinnvoll, wenn genügend freie Leistung vorhanden ist). Weiters war auch ein freier Rangfolgetausch-Prioritätentausch der Verbraucher nicht möglich.

Die Rotation im Sinne der Einbeziehung aller Verbraucher ist ebenfalls nicht möglich. Die im Programm enthaltene Rotation kann nur unter Verbrauchern gleicher Leistung so rotieren, daß immer nur einer in die Abschaltfolge miteinbezogen wird. Der Maximal ausbau von 37 Verbrauchern beschränkt das System auf gewisse Anlagengrößen und läßt keine Zusatzfunktionen wie z.B. Summenstörmeldeerfassung zu. Die Einhaltung des vorgegebenen Maximums ist rein von der Berechnung her nicht absolut sicher, da das System nicht erkennt, ob der zur Berechnung herangezogene Verbraucher eingeschaltet ist oder nicht.

Praktisch alle Hersteller von Gebäude-Leittechnik-Anlagen haben in ihre Systeme Maximumüberwachungen integriert.Dabei wird meist mit, dem Hauptrechner der Anlage untergeordneten, autarken DDC Stationen gearbeitet (programmierbare Digital steuerungen). Die Maximumüberwachung muß jedoch vom Zentralrechner durchgeführt werden, da sie gebäudeübergreifend arbeitet.

Zwei elementare Probleme treten dabei auf:
die Umlaufzeit beträgt im Durchschnitt etwa 1,5 Minuten. Bei einer Meßperiodendauer von 15 Minuten bedeutet dies eine Ungenauigkeit von 10%. Wird ein komfortables und umfassend effektives Maximumüberwachungsprogramm eingesetzt, so belegt dieses Programm einen relativ großen Haupt-Speicherbereich (300 kB) und benötigt entsprechende Rechenzeit, während der Rechner für andere Aufgaben blockiert ist.

Zentrale Maximumwächter erfordern einen großen Leitungsinstallationsaufwand und müssen wegen der an den großen Leitungslängen möglichen auftretenden elektrischen und magnetischen Störpegel überdimensional gesichert werden.

Die Optimierung des Soll-Wertes ist sehr personal intensiv und daher sehr kostenaufwendig. Meist wird diese sehr wichtige Aufgabe dann in der Praxis nicht durchgeführt.

Durch die vorliegende Erfindung sollen die vorstehend beschriebenen Nachteile vermieden werden.

Ziel ist eine bestmögliche Ausschöpfung des vorhandenen Tarif-Leistungspotentials mittels verknüpfter Berechnungsvorgänge.

Möglichst viele Verbraucher sollen in die Überwachung mit einbezogen werden. Es sollen den Erfordernissen entsprechende sensitive Schaltmöglichkeiten für die einzelnen Verbraucher und eine einfache freie Programmierung im Dialogverfahren gegeben sein.

Die US-PS 4 075 699 offenbart eine Zu- und Abschaltung von Verbrauchern. Dabei sind allerdings die Verbraucher derart mit dem Zentralrechner verbunden, daß jeder Verbraucher seinen Systemzustand rückmeldet. Dies erfordert in nachteiliger Weise einen erheblichen Aufwand an Kommunikationsmittel, der gemäß vorliegender Erfindung auf einem Minimum gehalten werden soll.

Die Datenübertragung soll in "Echtzeit" bei größtmöglicher Datensicherheit erfolgen. Ein programmierbarer Betriebsfortlauf soll auch bei Anlagen-Ausfall gewährleistet sein.

Weitere vorteilhafte Merkmale sollen sein: Einbindungsmöglichkeit von extern angeordneten Schaltelementen; Erfassung und Verknüpfung von externen Betriebszuständen; Einbindung von elektrischer Nachtspeicherofenregelung; Einbindung von Raumtemperaturregelung elektrischer Fußbodenheizung; Echtzeitschaltungsmöglichkeit von Beleuchtung; Anwählbarkeit mehrerer Maxima; Sollwert-Selbstfindung in vorwählbarem Bereich; cos phi Korrekturmöglichkeit des Soll-Wertes; 4-Bereichszeitschaltung aller Ausgänge; Verknüpfungsmöglichkeit aller Programmteile und der Übergabepunkte untereinander mit wählbarer Unterordnung in die Maximumüberwachung sowie Zählung der Arbeit in kWh und deren Verwertung.

Durch die vorliegende Erfindung werden die vorgenannten Nachteile vermieden und die gewünschten Vorteile erzielt. Die erfindungsgemäßen Merkmale sind den Patentansprüchen, der Beschreibung und den Zeichnungen zu entnehmen.

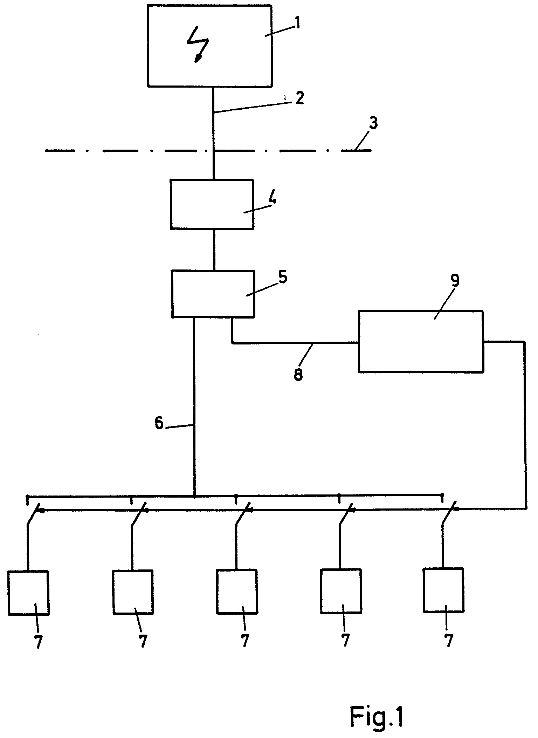

Die Fig. 1 bis 11 zeigen schematisch Diagramme und Schaltbilder.

Die Fig.1 zeigt grob schematisch eine Übersicht über eine Stromversorgung eines Kunden. Vom Elektrizitätsversorgungsunternehmen (EVU) 1 gelangt der Strom über die Leitung 2 in den Bereich 3 des Kunden bis zum E-Werk-Zähler 4. Diesem E-Werk-Zähler ist ein betriebseigener Zähler 5 nachgeschaltet, von dem der Strom über die Leitung 6 an die einzelnen Verbraucher oder Verbrauchergruppen 7 gelangt. Über die Leitung 8 gelangen Zählerinformationen zum Maximumwächter 9, der wahlweise die einzelnen Verbraucher 7 hinsichtlich der Stromversorgung freigibt oder sperrt. Freigeben heißt, daß die Verbraucher Strom verbrauchen dürfen, soferne nicht andere Schaltparameter wie Temperaturregelung, Zeitschaltung oder Überlastschalter wirksam werden.

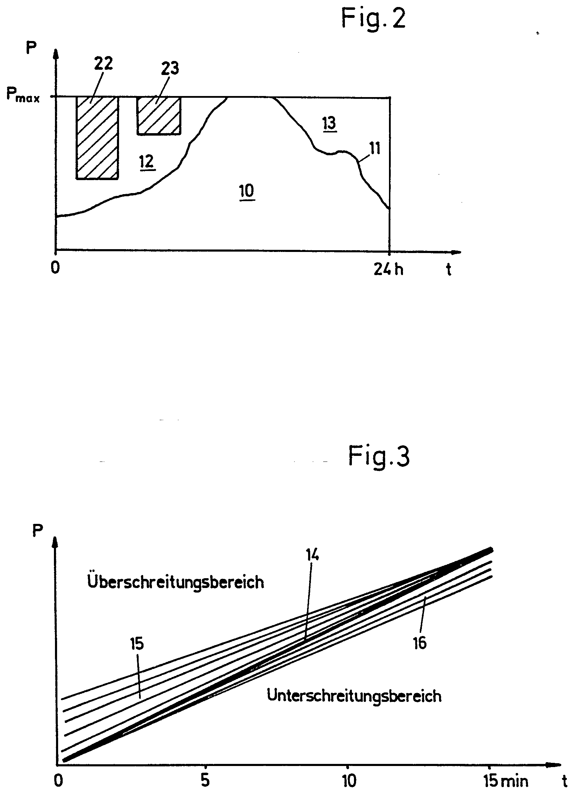

Fig.2 zeigt in einem Leistungs-/Zeitdiagramm den willkürlich angenommenen Tagesverlauf der Leistungskruve, wie er von den Zählern 4, 5 gemessen werden kann. $P_{max}$ ist die maximale Leistung, die zufolge des Maximumwächters nicht überschritten wird. Die Fläche 10 unterhalb der Ist-Wertkurve 11 stellt die tatsächlich geleistete Arbeit dar. Die Flächen 12, 13 zwischen $P_{max}$ und der Leistungskurve 11 sind die freien Bereiche, die gegenüber der maximalen Leistung (und damit bezahlten Leistung) ungenutzt sind.

Bisher war eine Nutzung der freien Bereiche nur durch empirisches Feststellen des Kurvenverlaufes 11 und zeitbezogenes Einschalten gewisser Verbraucher möglich, wie dies durch die Flächen 22, 23 schematisch angedeutet ist. Es wurden also aufgrund der Erfahrungswerte bestimmte Verbraucher nur zu bestimmten Zeiten des Tagesablaufs zu- und wieder abgeschaltet. Eine Berücksichtigung des tatsächlichen Stromverbrauches und somit der tatsächlichen Verhältnisse konnte nicht erzielt werden.

Bei der vorliegenden Erfindung wird hingegen ein leistungsabhängiges Einschalten verschiedener Verbraucher erzielt.

Durch die Integralstufen werden Prioritätsstufen vorgegeben. Es sind dies Prozentstufen, nämlich Prozent des Uberschreitungswertes vom Soll-Wert.

Tendenzstufen bedeuten, daß Verbraucher, die durch Zeitschaltung von normaler Soll-Ist-Wertberechnung weggeschalten sind, definitionsgemäß einer Tendenzstufe zugeordnet werden können.

Fig.3 zeigt schematisch gemäß Erfindung die Integralberechnung des Soll-Ist-Wertes im Leistungs-/Zeitdiagramm über den vom Versorgungsunternehmen vorgeschriebenen Berechnungszeitraum von 15 Min. Zu dem eingestellten Soll-Wert 14 existieren Überschreitungs- und Unterschreitungsbereiche 15, 16, wobei jedem Überschreitungsbereich ein Unterschreitungsbereich zugeordnet ist.

Der jeweilige Über- und Unterschreitungswert bezieht sich immer auf den eingestellten Soll-Wert. Alle Werte können in absolute Zahlen umgerechnet werden, was z.B. beim Soll-Ist-Wert-Vergleich in den Anzeigedisplays geschehen kann. Jeder der verwalteten Verbraucher kann einer dieser Kombinationen aus Über- und Unterschreitungswert zugeordnet werden. Die Zuordnung mehrerer Verbraucher zu einer dieser Kombinationen ist ebenfalls möglich. Vorteilhaft werden in diesem Fall mehrere Verbraucher nicht gleichzeitig sondern mit einer Abund Zuschaltverzögerung von 50 Millisekunden geschaltet.

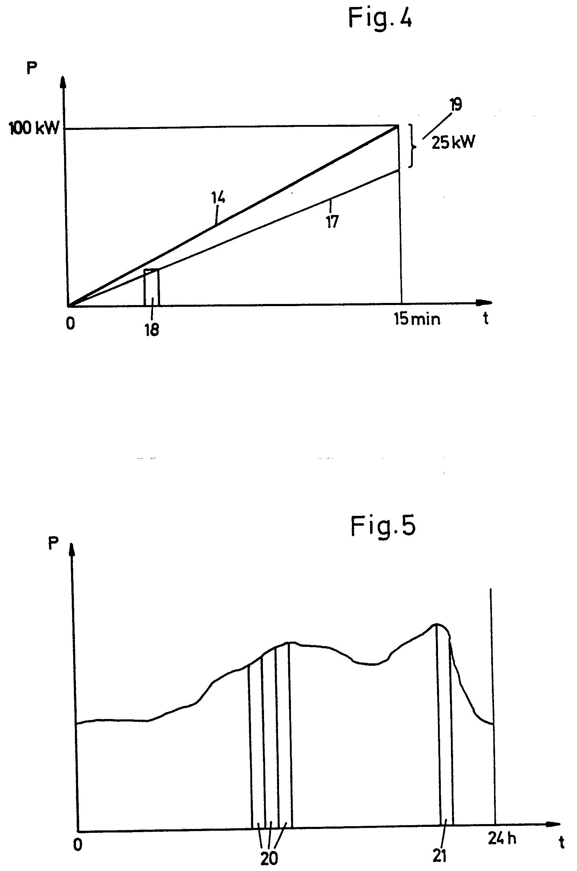

Der Fig.4 ist die Tendenzberechnung zu entnehmen. In dem zuvor genannten Meßintervall von 15 Min. ist z.B. ein Soll-Wert 14 vorgegeben, der nach 15 Min. einer geleisteten Arbeit von 100 kW entspricht. Der Ist-Wertverlauf 17 des Stromverbrauches wird innerhalb von Tendenzmeßzeiten 18 gemessen und hochgerechnet. Die Hochrechnung ergibt eine freie Leistung 19 von beispielsweise 25 kW.

Wenn gemäß Erfindung z.B. Tendenzstufen 1 und 2 vordefiniert sind, wobei die Tendenzstufe 1 = 20 kW und 2 = 10 kW, wird nunmehr zuerst die Tendenzstufe 1 zugeschaltet und später, sobald die Tendenzberechnung wieder einen freien Bereich genügender Größe anzeigt, die Tendenzstufe 2 eingeschaltet. Die Tendenzstufen sind somit vordefinierte Verbraucher, die gemeinsam in einer bestimmten Reihenfolge zugeschaltet werden können.

Der Berechnungszeitraum 18 für die Tendenzberechnung beträgt bevorzugt 120 sek., die Berechnungszeitpunkte können alle 4 sek. aufeinander folgen.

Bisher sind Tendenzberechnungen nur zum Abschalten von Verbrauchern herangezogen werden. Zeigte dabei die Tendenzberechnung, daß der eingestellte Soll-Wert überschritten wird, wurden die Verbraucher abgeschaltet.

Bei der vorliegenden Erfindung wird hingegen leistungsbezogen der freiverfügbare Bereich immer neu errechnet, und es werden nach bestimmten Prioritäten die Verbraucher oder Verbrauchergruppen zugeschaltetn, wenn die Tendenzberechnung den freien Bereich anzeigt. Es kommt zu einer vorteilhaften Verknüpfung der Integralberechnung mit der Tendenzberechnung.Durch die Integralberechnung werden alle Verbraucher berücksichtigt, die vom Maximumwächter freigegeben sind. Jeweils zu Beginn jeder der 15 Min. Meßperiode werden alle Verbraucher freigegeben. Dies bedeutet, daß alle Verbraucher eingeschaltet werden, soferne sie nicht aus anderen Gründen (z.B. Zeitschaltung) ausgeschaltet sind.

Ein weiteres vorteilhaftes Merkmal der Erfindung ist die Soll-Wert-Selbstfindung. Bisher wurde aufgrund des Kurvenverlaufes im 24-stündigen Leistungs-/Zeitdiagramm festgestellt,wie die Spitzenverbrauchswerte liegen. Bei der Erfindung wird unter Vorgabe bestimmter Parameter der Soll-Wert selbsttätig eingestellt. Dies ist vor allem für die Berücksichtigung selten vorkommender Verbrauchsereignisse vorteilhaft. Ein typisches Beispiel ist in der Hotellerie die Sylvesternacht.

Fig.5 zeigt einen Ist-Wertverlaufim Tagesablauf mit eingezeichneten 1/4-Stunden-Spitzen 20.Aufgrund der vorgegebenen Tarifberechnung kann die eine rechte Spitze 21 den gesamten Monatswert für die tarifmäßige Leistung festlegen.

Zur Höchstspitze ist zu beachten, daß vom E-Werk immer ein oberster Soll-Wert vorgegeben ist, der z.B. dem Anschlußwert oder dem Ansprechwert eines Uberlastschutzes entspricht. Weiters existiert ein unterer Soll-Wert in der Höhe von 2/3 des oberen Soll-Werts und für diesen Soll-Wert wird die Grundgebühr bezahlt. Es hat tarifmäßig keinen Vorteil, im Stromverbrauch unter diesen Soll-Wert zu gehen, da dieser Verbrauch jedenfalls zu bezahlen ist.

Wenn somit eine Spitze im Verbrauch schon aufgetreten ist, wie dies im Diagramm 5 rechts eingezeichnet ist, dann ist damit der Soll-Wert auf den Wert dieser Spitze für den ganzen Monat festgelegt. Es ist damit tarifmäßig sinnvoll, diesen Soll-Wert zur Gänze auszunutzen. Gemäß Erfindung wird somit der Soll-Wert angehoben und dieser Soll-Wert entspricht dem Soll-Wert 14 der vorhergehenden Diagramme.

Je nach gewünschter Schaltung des Gerätes kann z.B. eine Herabsetzung des Soll-Wertes dann erfolgen, wenn nicht in den vergangenen 10 Tagen wenigstens 20 Spitzen aufgetreten sind. War dies der Fall, dann bleibt der Soll-Wert auf dem erhöhten Niveau. Wenn in den vergangenen 10 Tagen weniger als 20 Spitzen aufgetreten sind, dann fällt der Soll-Wert auf den Mittelwert der letzten 20 Spitzen. Alle diese angeführten Parameter sind jedoch frei einstellbar. Die Soll-WertVeränderung tritt vorteilhafterweise immer nur mit Monatsende in Kraft. Es ist der Beginn des neuen Ablesezeitraumes. Weiters kann vorgesehen sein, daß durch freie Tage (Sperrtage, wie Wochenende) keine Verschiebung des Soll-Wertes hervorgerufen wird.

Durch die Soll-Wert-Selbstfindung ist es möglich, eine Leistungsspitzenopitmierung automatisch durchführen zu lassen. Als Parameter können eingesetzt werden: variable Berechnungszeit, Fixierung der oberen und unteren Soll-Wert-Selbstfindungsgrenzen, Anzahl der auftretenden Höchst- oder Niedrigstspitzenwerte für die Veränderung des Soll-Wertes, Vorgabe von Sperrtagen.

Manche leistungsmäßig ausgeschöpften vorgelagerten Anlagenteile wie Transformator und Energiekabel können es notwendig machen, neben der Tarifmäßigen 1/4-Stunden-Begrenzung eine Momentan-Leistungsbegrenzung vorzusehen. Um eine mathematisch und anwendungsorientiert einwandfreie Berechnungsgrundlage für eine Momentanleistungserfassung zu erhalten, ist eine hohe Impulswertigkeit wie z.B. 6000 Impulse pro kWh notwendig. Um auch in Schwachlastzeiten eine ruhige Anzeige zu erhalten,kann man z.B. eine Zählfensterzeit von 20 sek. mit einer Berechnungswiederholung alle 4 sek. wählen.

Die Berechnung der Momentanleistungsbegrenzung kann bei der vorliegenden Erfindung mit den Verbrauchern von bestimmten Integralstufen verknüpft werden, beispielsweise mit den ersten fünf Integralstufen. Bei Anwendung dieser Verknüpfungsart sind diese Integralstufen entsprechend selektiv zu belegen.

Vorteilhafterweise wird bei einer Abschaltung durch die Momentanleistungsbegrenzung nur die Zu- und Abschaltverzögerung bei Prioritätsgleichheit (z.B. 50 Millisek.) berücksichtigt und nicht die minimalen oder maximalen Ausschaltzeiten.

Ein weiters vorteilhaftes Merkmal ist die sogenannte Rotation.

Bei der Zuordnung bestimmter Verbraucher zu bestimmten Integralstufen und Tendenzstufen tritt das Problem auf, daß bestimmte Stufen immer als erstes abgeschaltet werden und somit weniger Einschaltzeit erhalten, als alle anderen. Bei der Rotation werden nun diese Stufen umgewertet, wobei die Rotationsstufen der Reihe nach ablaufen, und jede Rotationsstufe immer wieder andere Integral- oder Tendenzstufen beinhaltet.

Weiters ist die Integralgrenzwertkorrektur ein vorteilhaftes Merkmal. Es wird dabei der größtmögliche Überschreitungsprozentwert der Integralstufen (siehe Fig.3) korrigiert. Es kann zu Problemen kommen, wenn innerhalb der 15-minütigen Meßintervalle Veränderungen der Abschaltzeiten von Verbrauchern durchgeführt werden. Die Lösung besteht darin, daß die Änderung der Abschaltzeit erst mit Ende des Meßintervalls wirksam wird. In Fig.3 sind Integralgrenzwerte mit den Bezugszeichen 15, 16 versehen. Der Überschreitungswert in kW berechnet sich erfindungsgemäß nach folgender Formel:

$$\text{Überschreitungswert (kW)} = \frac{\text{abschaltbare Leistung (kW)}}{15 \times \text{Abschaltzeit (Min.)}}$$

Die vorgenannten Integralstufen, Tendenzstufen, Rotationsstufen, die Meßwertverarbeitung und gegebenenfalls ein Notstromprogramm können als Parameter verschiedenen Programmstufen zugeordnet werden und mit UND sowie ODER Verknüpfungen belegt werden. Sind mehrere Ebenen gefordert, so können auch die Programmstufen untereinander verknüpft werden.

Beispiele für Programmstufenverknüpfungen können sein: Kopplung mehrerer Eingänge bei Störmeldungen, Verknüpfung mehrerer Lichtschalter mit einem Beleuchtungskörper, Umschaltung eines Verbrauchers vom Bezugsausgleichsprogramm auf die integrale Abschaltung mittels einer externen Anweisung über ein Eingangssignal, etc.

Das zuvor genannte Notstromprogramm hat zur Voraussetzung einen entsprechenden Notstromschienenaufbau der Anlage, eine unterbrechungsfreie On-Line-Stromversorgung für den erfindungsgemäßen Maximumwächter und entsprechende Notstromanlagen für diverse Verbraucher. Die Ausgabemodule können mit einem Notprogramm parametrisiert werden.

Der Programmablauf kann die nötigen unverzögerten Abschaltvorgänge, die Ausschaltdauer der Gesamtanlage, das verzögerte Einschalten der für den Anlaufbetrieb des Notstromaggregates vorgesehen Verbraucher, verzögerte Einschaltung der für den Notstromdauerbetrieb definierte Verbraucher, Einhaltung einer definierten Notstrommomentanleistungsspitze, Netzwiederkehr mit Umschaltung von der Notstromverschienung auf die Standardverteilung und die zeitverzögerte Zuschaltung aller vor dem Netzausfall im Betrieb gewesenen Verbraucher berücksichtigen.

Die Meßimpulsverarbeitung und Steuerung erfolgt in einem geeigneten Rechner mit einer entsprechenden Software. Die folgenden Angaben sind beispielsweise.

Die von einem Impulsgeberzähler ausgegebene Anzahl der Kontaktierungen wird im Zählmodul in verschiedenen Formen so lange gespeichert, bis eine entsprechende Abfrage von der CPU, also dem Hauptrechner, erfolgt. Speicherarten können sein: Impulsanzahl der laufenden Meßperiode, Impulsanzahl der letzten Meßperiode, Impulsanzahl bis zur letzten Verbrauchsabfrage. Die Verbrauchsabfrage wird bevorzugt alle 4 sek. durchgeführt. Aus Sicherheitsgründen 2mal hintereinander. Nachdem der Wert der zweiten Abfrage mit der ersten verglichen wurde, erfolgt die Löschung des entsprechenden Speichers im Zählmodul.Stimmen beide Werte überein, erfolgt die Übernahme in die Berechnung. Differieren beide Werte, wird die Einbindung in die Berechnung nicht durchgeführt, der Wert wird verworfen.

Die Empfangsdaten werden bevorzugt einem Syntaxtest unterzogen, wobei es zu einer Überprüfung aller übertragenen Zeichen auf Position und Code kommt. Eine Plausibilitätsprüfung besteht aus dem Vergleich der empfangenen Werte der Doppelabfrage, wobei die Abweichtoleranz aus den Impulsgeberzähler-Parametern und der gewählten Baudrate errechnet wird. Liegen die Werte außerhalb des Toleranzfensters, erfolgt eine neuerliche Abfrage. Zudem wird der Impulszuwachs mit dem vorheriger Toleranzfenster verglichen. Ist ein Prüfergebnis negativ, wird der Meßwert verworfen.

Zur Beeinflußung der maximalen Ausschaltzeiten kann eine Intervall-Schaltung vorgesehen werden. Neben der gesamten Ausschaltzeit kann die Zeitdauer in ein Impuls - Pause Verhältnis gesetzt werden, z.B. bei 4 Min. Gesamtausschaltdauer in einer Meßperiode, 1 min. Aus, 2 min. Ein und 1 min. Aus.

Jeder der in der Standard Systemsoftware eingebundenen Ausgänge kann bevorzugt mit folgenden Variablen in 4 verschiedenen Zeitbereichen pro Tag versehen werden:

Integralberechnung : 10 Stufen
Tendenzberechnung : 10 Stufen
Rotation Verknüpfungs-Programm : 32 Stufen

"Und" Verknüpfung mit 1 Eingang
Intervall Schaltung
Mindestabschaltzeit (bis 99 min)
Maximalste Abschaltzeit (Meßperiodendauer)
EIN
AUS
Zeitschaltung

Ist der aktuelle Zählerimpulswert kleiner als der vorhergehende, erfolgt eine Synchronisierungsanregung. Bei Ablauf von mehr als 99 % der Meßperiodenzeit wird sofort synchronisiert, andernfalls wird die nächste Abfrage abgewartet.

Die Tarifleistungsberechnung (Soll-Ist-Wert Vergleich) errechnet sich aus dem aktuellen Impulswert und den Basisparametern.

Nach jeweils 3 Abfragen wird aus der Intervallzeit, der Impulsdifferenz zum letzten Berechnungsintervall und den Basisparametern die Momentanleistung ermittelt. Zur Dämpfung von Leistungssprüngen, sowohl an der Anzeige, wie auch zur Momentanleistungsberechnung wird der Durchschnitt mit dem vorhergehenden Wert gebildet.

Tendenzermittlung; gleich der Momentanleistungsberechnung werden die Impulswerte im Dreierzyklus in zehn Rotationsspeichern abgelegt. Die Tendenzleistung ermittelt sich aus der aktuellen Tarifleistung, dem Sockelwert, und der aus den Impulswerten des ersten und letzten Rotationsspeichers errechneten Leistung. Das Ergebnis ist ein Leistungsäquvalent über 4x3x10 Sekunden, nämlich 4 sek. Abfragezyklus, 3 Abfragen und 10 Rotationsspeicherablagen,also ein Leistungsäquivalent der Meßdauer von 12 sek., das alle 12 Sekunden erneuert wird.

Um höchste Flexibilität und minimalsten Verdrahtungsaufwand bei der Hardware zu gewährleisten, werden alle Verbraucher durch Interface, nachstehend als Eingangs-, Ausgangs-, Zähl- und Analogmodule bezeichnet, vor Ort gesteuert oder Meßwerte aufgenommen. Die Module haben den charakteristischen Schaltungsaufbau einer speicherprogrammierbaren Steuerung. Da auch sehr zeitkritische Anwendungen durchgeführt werden, ist eine rasche und störsichere und somit fehlerfreie Übertragung zu gewährleisten. Medium dieser Übertragungstechnik ist ein koaxialer Leitungszug, der an seinen beiden Enden dem Wellenwiderstand entsprechend abgeschlossen ist (Kunstantenne). Auf Grund dieses hochfrequenzgerechten Aufbaues kann bidirektional mit hohen Datenraten bei großer Störsicherheit übertragen werden.An jeder beliebigen Stelle des Leitungszuges können,unter Berücksichtigung der Anpassung, Daten eingespeist oder entnommen werden. Die einzelnen, in den Leitungszug einbezogenen Komponenten verhalten sich bei Ausfall oder Abschaltung passiv, sodaß das Gesamtnetz weiterhin funktionstüchtig bleibt.

Den Datenaustausch zwischen den Modulen aktiviert die Zentraleinheit durch Aussenden von Adressen (Gerätenummern). Die Daten werden nur vom selektierten Modul verarbeitet bzw. Antworten zurückgesandt. Zur Vermeidung von Fehlern werden zum Dateninhalt Prüfdaten hinzugefügt, vom Zielmodul die Korrektheit geprüft und auf Wunsch auch bestätigt. Das Koaxialkabel bietet durch seine Schirmung einenweitgehenden Schutz gegenüber Störimpulsen.

Je nach Länge der Koaxleitung, und damit der Kapazität, werden die Schaltflanken verschliffen. In einer speziell dafür entwickelten Empfangsschaltung werden diese Flanken wieder rekonstruiert und der CPU als Information wieder angeboten.

Eine optimale Abstimmung zwischen Ubertragungsgeschwindigkeit und Reichweite ergibt sich beispielsweise bei 19200 Baud bei 1000m Reichweite. Dabei ist eine ausreichende Reserve gewährleistet. Es kann mit jeder gängigen Baudrate zwischen 300 und 19200 gearbeitet werden. Bei Herabsetzung der Ubertragungsdistanz auf unter 500m kann auch mit einer Datenrate von 38 000 Baud gearbeitet wird.

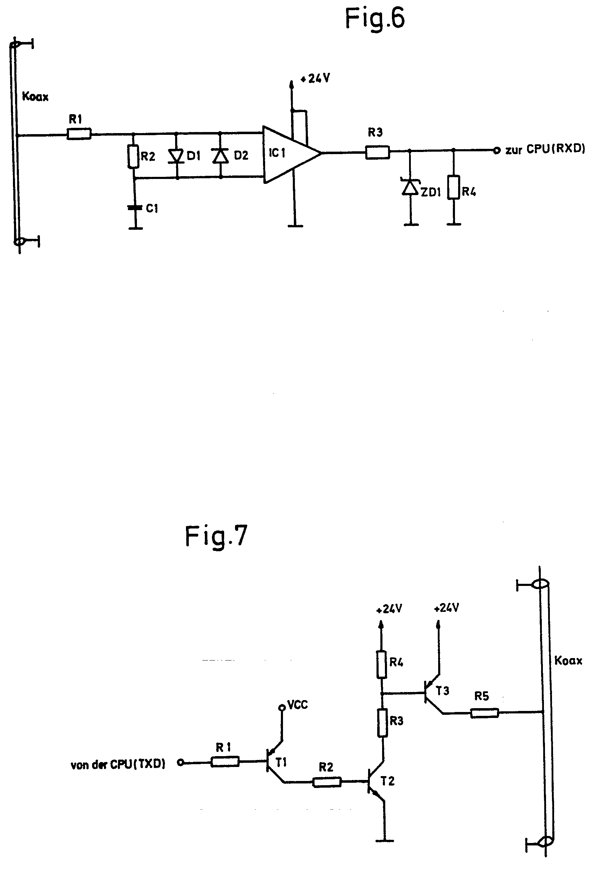

Fig.6 zeigt die Empfangsschaltung.Ein Operationsverstärker wird mittels Offset in einer definierten Ausgangslage gehalten (Ruhelage für Dateneingang der CPU). R1 koppelt vom Koax hochohmig das Datensignal aus. Nach Überschreiten der Offsetspannung wird der OP-Ausgang umgeschaltet. D1 ladet über R1 nach Erreichen der Durchlaßspannung den "Schleppkondensator" C1 auf. Nach Ende des Datenimpulses wird vom C1 die Ladung gehalten und der OP schaltet in die Ruhelage zurück. D2 beschleunigt nach Erreichen der Durchlaßspannung das Entladen von C1. Die Bauteile am Ausgang des OP sorgen für ein CPU-gerechtes Signal. Durch das hochohmige Abtasten wird impedanzmäßig eine Beeinflussung der Koaxleitung vermieden.

Fig.7 zeigt die Senderschaltung. Der serielle Datenausgang der CPU steuert über die Treiberstufe T1 und T2 den Leistungstransistor T3. Dieser wird über T5 impedanzrichtig an das Koaxkabel angekoppelt. Bei korrektem Betrieb sendet immer nur eine Komponente und schaltet damit den Innenleiter zwischen 0 Volt und halber Modulbetriebsspannung.

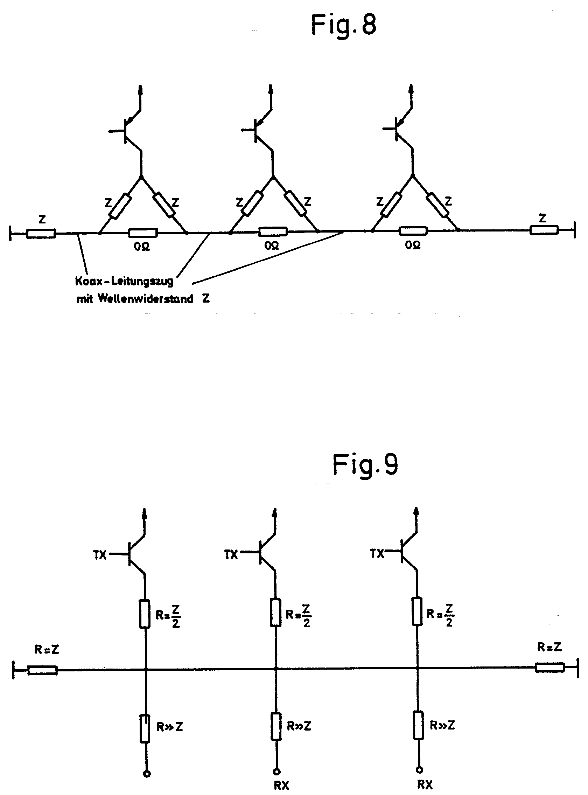

Fig.8 zeigt ein HF-Ersatzschaltbild. Hier sieht man die Widerstandstransformation zur Einkopplung der Sendersignale sowie den HF-mäßigen Abschluß der Koaxleitung zur Verhinderung von Reflexionen.

Fig.9 stellt die Realisierung des Leitungszuges dar. Bedingt durch die 0 Ω Verbindung können die beiden Kopplungswiderstände zusammengefaßt werden. Der Widerstand muß den halben Ohmschen Wert des Wellenwiderstandes besitzen.

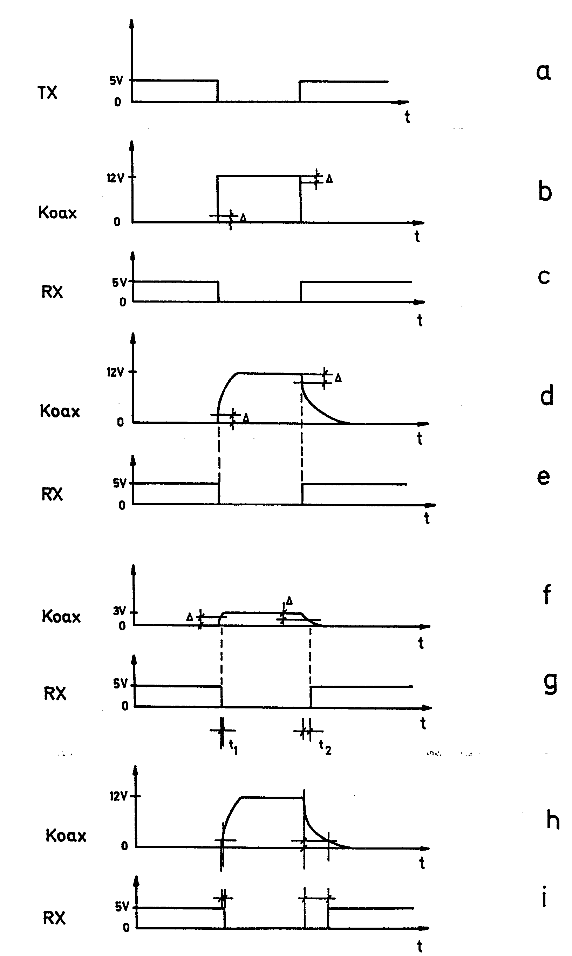

Die Fig. 10 zeigt den Signalverlauf im Koaxkabel; a zeigt den Ausgang der CPU mit einem Impuls; b zeigt das zugehörige Signal an der Koaxbüchse bei ordnungsgemäßen Abschluß sowie kürzester Leitungsschaltung. Es tritt hierbei keine Signalverzerrung auf; c: so decodiert die Empfangsschaltung vorheriges Signal für die CPU; d zeigt den Signalverlauf an der Senderbuchse bei maximaler Kabelbeschaltung (1000m); e zeigt das zugehörige Empfangssignal; f zeigt das Signal nach 1000 Metern; g zeigt das zugehörige Empfangssignal, hierbei kommt es zur maximal möglichen Verzerrung; h und i zeigen die Verzerrung ohne "Schleppkondensator" bei gleicher Ansprechschwelle,was hier aber nicht zum Einsatz kommt.

Wie man sieht, erfolgt die Signaltransformation derart, daß die Flanken des Digitalsignales durch die jeweils mit Δ gekennzeichneten geraden Kurvenstücken des einlangenden Signales gesetzt werden. Damit werden Leitungsverzerrungen weitgehend ausgeschaltet.

Somit kann mit hoher Übertragungsgeschwindigkeit auch über große Leitungslängen gefahren werden. Dadurch werden zeitkritische Meß- und Schaltsignale rasch genug übertragen, um die notwendige Meßgenauigkeit und Schaltgeschwindigkeit auch bei großen Systemen zu erzielen. Sehr zeitkritisch sind z.B. Einschaltvorgänge bei der Beleuchtung.

Beispielsweise ist bei einer Meßgenauigkeit von 1% eine Zeitdauer von max. 9 Sekunden für Meßerfassung, Umsetzung und Ausgabe (Schaltvorgang) einzuhalten.

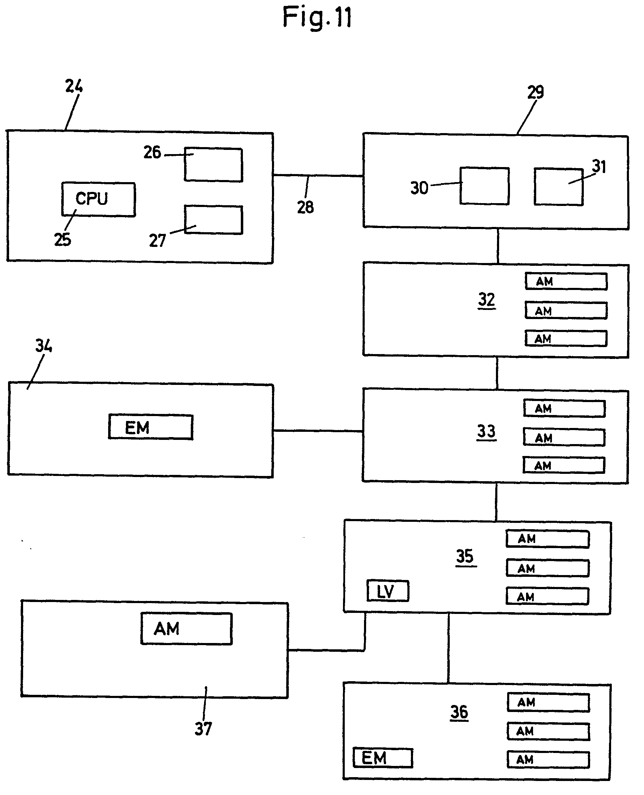

Fig.11 zeigt eine Übersicht über eine erfindungsgemäße Anlage. Die Zentrale 24 umfaßt die CPU 25 mit einem Signalumsetzer 26 (siehe Fig.7) und einem sogenannten "watchdog" 27 zur Überwachung, ob die CPU richtig arbeitet. Der Signalumsetzer 26 übergibt das Signal an das Koaxkabel 28. Der Zähler 29 sitzt bevorzugt bei der Kraftstromeinspeisung und umfaßt einen Impulsgeberzähler 30 und ein Zählmodul 31 mit Echtzeituhr. Die Module 32 bis 37 zeigen schematisch Ausgangsmodule AM und gegebenenfalls auch Eingangsmodule EM und das Modul 35 einen Leistungsverstärker LV für Leitungslängen über 1000 m oder für Leitungsverzweigungen.

Die Ausgangsmodule AM stellen die von der Zentrale gesteuerten Verbraucherschalter dar. Die Eingangsmodule EM stellen Schaltzustände oder Parameter der Anlage fest und melden diese an die CPU.

## Patentansprüche

1. Maximumwächter, insbesondere für die Tarifberechnung, wobei von einem Maximumzähler der von einem Stromkunden innerhalb eines Abrechnungszeitraumes in einem vorgegebenen Meßintervall gemessene Spitzenverbrauch ermittelt wird und vom Maximumwächter Verbrauchergruppen unter Einhaltung des Spitzenverbrauchswertes wahlweise abgeschaltet und wieder zugeschaltet werden und wobei eine Integralrechnung durchgeführt wird, wobei jeder Verbrauchergruppe ein zu einem Sollwert im Leistungs-Zeit-Diagramm vorgegebener Überschreitungswert und ein Unterschreitungswert zugeordnet ist, dadurch gekennzeichnet, daß die Zuschaltung und gegebenenfalls auch die Abschaltun von Verbrauchern von einer Tendenz gemäß einstellbarer Tendenzstufen, die als vorgewählte Verbrauchergruppen definiert sind, gesteuert ist, wobei die Zuschaltung erfolgt, wenn die Tendenzberechnung einen genügend großen freien Leistungsbereich ergibt.

2. Maximumwächter nach Anspruch 1, dadurch gekennzeichnet, daß innerhalb jeder Verbrauchergruppe jeder Verbraucher mit einer einstellbaren Zeitverzögerung, etwa 50 Millisekunden, ab- und zuschaltbar ist.

3. Maximumwächter nach einem der Ansprüche 1 oder 2, dadurch gekennzeichnet, daß sowohl die Integralberechnung als auch die Tendenzberechnung im Zeittakt, wie etwa 4-Sekundenzeittakt, erfolgt.

4. Maximumwächter nach einem der Ansprüche 1 bis 3, dadurch gekennzeichnet, daß die Tendenzstufen mit je einer der Integralstufen frei wählbar verknüpft sind, wobei gegebenenfalls frei bestimmbare Zu-und Abschaltverzögerungszeiten vorgebbar sind, um zu große Lastschaltungen zu vermeiden.

5. Maximumwächter nach einem der Ansprüche 1 bis 4, dadurch gekennzeichnet, daß der Sollwert (14) im Zeit-Leistungsdiagramm für eine Abrechnungsperiode aus einer frei definierbaren Zahl an 1/4-Stundenspitzen der vorangegangenen oder einer der vorangegangenen Abrechnungsperiode errechnet ist.

6. Maximumwächter nach Anspruch 5, dadurch gekennzeichnet, daß die Sollwertveränderung mit Beginn der Abrechnungsperiode in Kraft tritt.

**7.** Maximumwächter nach Anspruch 5 oder 6, dadurch gekennzeichnet, daß bei der Berechnung der Sollwertveränderung wählbare Zeiträume unberücksichtigt sind.

**8.** Maximumwächter nach einem der Ansprüche 1 bis 7, dadurch gekennzeichnet, daß für die Momentanleistungserfassung und eine MomentanLeistungsbegrenzung eine hohen Meßimpulsrate pro Arbeitseinheit (kWh), bevorzugt höher 3000 Impulse/kWh, vorgesehen ist.

**9.** Maximumwächter nach Anspruch 8, dadurch gekennzeichnet, daß die Momentan-Leistungsbegrenzung mit den Verbrauchern von vorbestimmbaren Integralstufen verknüpft ist.

**10.** Maximumwächter nach Anspruch 9, dadurch gekennzeichnet, daß bei der Abschaltung durch die Momentanleistungsbegrenzung eine Zu- und Abschaltverzögerung, etwa 50 Millisekunden, gegeben ist.

**11.** Maximumwächter nach einem der vorhergehenden Ansprüche, dadurch gekennzeichnet, daß die Integralstufen und Tendenzstufen zeitlich aufeinanderfol gend verschiedenenRotationsstufen zugeordnet sind, die der Reihe nach ablaufen.

**12.** Maximumwächter nach einem der vorhergehenden Ansprüche, dadurch gekennzeichnet, daß der größtmögliche Uberschreitungswert der Integralstufen korrigierbar ist und nach folgender Formel bestimmt ist:

$$\text{Überschreitungswert (kW)} = \frac{\text{abschaltbare Leistung (kW)}}{15 \times \text{Abschaltzeit (Min.)}}$$

**13.** Maximumwächter nach einem der vorhergehenden Ansprüche, dadurch gekennzeichnet, daß für den Datenaustausch zwischen Zentrale (24), Ausgabemodulen (AM) und Eingabemodulen (EM) eine Koaxleitung vorgesehen ist.

**14.** Maximumwächter nach Anspruch 13, dadurch gekennzeichnet, daß für den Empfang der über das Koaxkabel hereinkommenden Signale eine Empfangsschaltung vorgesehen wird, bei der das Datensignal vom Koax über einen Widerstand R1 hochohmig ausgekoppelt ist, ein Operationsverstärker mittels Offset in einer definierten Ausgangslage gehalten ist, der OP-Ausgang nach Überschreiten der Offsetspannung umgeschaltet wird und nach Erreichen der Durchlaßspannung von einer Diode D1 über einen Widerstand R1 der Kondensator C1 als Schleppkondensator aufgeladen wird, sodaß nach Ende des Datenimpulses die Ladung vom Kondensator C1 gehalten und der OP in die Ruhelage zurückgeschaltet wird.

**Claims**

**1.** A maximum demand controller, in particular for tariff calculations, in which arrangement an electricity customer's peak demand, metered within an accounting period in a predetermined metering interval, is ascertained by a maximum demand counter, and groups of consuming devices are selectively switched off and switched on again by the maximum demand controller while keeping to the peak consumption value, and in which arrangement an integral calculation is effected, in which procedure each group of consuming devices is assigned an excess of limit value and a falling below the limit value preset to a set point value in the power output-time diagram, characterized in that the switching on, and if applicable, also the switching off of consuming devices, is controlled by a trend according to adjustable trend stages which are defined as preselected groups of consuming devices, in which arrangement the switching on is effected when the trend calculation produces a sufficiently large free power range.

**2.** A maximum demand controller according to claim 1, characterized in that within each group of consuming devices, each consuming device can be switched off and switched on with a time delay of approximately 50 milliseconds.

**3.** A maximum demand controller according to one of claims 1 or 2, characterized in that both the integral calculation and the trend calculation is effected in a time sequence as, for ininstance, a 4-second time sequence.

**4.** A maximum demand controller according to one of claims 1 to 3, characterized in that the trend stages are coupled in a freely selectable mode with one each of the integral stages, in which arrangement, freely determinable switching-on and switching-off delay times may be set if required, so as to avoid unduly high load-switching operations.

5. A maximum demand controller according to one of claims 1 to 4, characterized in that the set point value (14) is calculated in the time-power output diagram for an accounting period from a freely definable number of 1/4 hourly peaks of a preceding, or one of the preceding, accounting periods.

6. A maximum demand controller according to claim 5, characterized in that the change in the set point value comes into force with the start of the accounting period.

7. A maximum demand controller according to claim 5 or 6, characterized in that in the calculation of the change in the set point value, selectable time periods are not taken into account.

8. A maximum demand controller according to one of claims 1 to 7, characterized in that for the detection of the instantaneous power output, and for an instantaneous power output limitation, provision is made for a high metering pulse rate per unit of work (kWh), preferably higher than 3,000 pulses/kWh.

9. A maximum demand controller according to claim 8, characterized in that the instantaneous power output limitation is coupled with the consuming devices of predeterminable integral stages.

10. A maximum demand controller according to claim 9, characterized in that in the case of the switching off by the instantaneous power output limitation, there is provided a switching-on and switching-off delay, of approximately 50 milliseconds.

11. A maximum demand controller according to one of the preceding claims, characterized in that the integral stages and trend stages are assigned to different rota stages following one another in time, which run off in succession.

12. A maximum demand controller according to one of the preceding claims, characterized in that the maximum possible excess of limit value of the integral stages can be corrected and is determined according to the following formula:

$$\text{Excess of limit value (kW)} = \frac{\text{output that can be switched off (kW)}}{15 \times \text{switching off time (min)}}$$

13. A maximum demand controller according to one of the preceding claims, characterized in that provision is made for a coaxial line for the data exchange between the central unit (24), output modules (AM) and input modules (EM).

14. A maximum demand controller according to claim 13, characterized in that for receiving the signals coming in via the coaxial cable, provision is made for a receiving circuit wherein the data signal from the coaxial cable is coupled out with a high resistance by means of a resistor R1, an operational amplifier is held in a defined output position by means of an offset, the OP-output is switched over after the offset voltage has been exceeded, and after the forward voltage has been reached, the capacitor C1 is charged as a pull-down capacitor by a diode D1 via a resistor R1, so that after the end of the data pulse, the charge is held by the capacitor C1 and the Op is switched back into its rest position.

## Revendications

1. Contrôleur de maximum, notamment pour la tarification, dans lequel la consommation de pointe mesurée dans un intervalle de mesure prédéterminée, d'un client au courant est mesurée par un compteur de maximum dans une période de temps de tarification et des groupes de consommateurs sont déconnectés ou à nouveau connectés par le contrôleur de maximum, au choix, en maintenant la valeur de consommation de pointe, et un calcul intégral est effectué et à chaque groupe de consommateurs est associé une valeur de passage au dessus et une valeur de passage en dessous d'une valeur de consigne prédéterminée dans le diagramme puissance - temps, caractérisé en ce que la connexion et, le cas échéant, également la déconnexion de consommateurs est commandée par une tendance en fonction de seuils de tendance réglable qui sont définies comme groupes de consommateurs présélectionnés, la connexion s'effectuant lorsque la tarification donne une gamme de puissance libre suffisamment grande.

2. Contrôleur de maximum selon la revendication 1, caractérisé en ce qu'à l'intérieur de chaque groupe de consommateurs, chaque consommateur peut-être connecté ou déconnecté à un retard réglable d'environ 50 millisecondes.

3. Contrôleur de maximum selon la revendication 1 ou 2, caractérisé en ce qu'à la fois le calcul intégral et le calcul de tendance se fait à une cadence telle qu'une cadence de 4 secondes.

4. Contrôleur de maximum selon l'une des revendications 1 à 3, caractérisé en ce que les seuils de tendance sont reliés de façon à pouvoir être librement choisis, à l'un des seuils intégraux, le cas échéant des temps de retard de connexion et déconnexion, pouvant être librement déterminés, sont susceptibles d'être prédéterminés pour éviter des connexions de charges trop importantes.

5. Contrôleur de maximum selon l'une des revendications 1 à 4, caractérisé en ce que la valeur de consigne (14) est déterminée dans le diagramme temps-puissance pour une période de tarification à partir d'un nombre pouvant être librement définie de pointes d'un quart d'heure de la période de tarification précédente ou de l'une des périodes de tarification précédentes.

6. Contrôleur de maximum selon la revendication 5, caractérisé en ce que la variation de la valeur de signes entre en vigueur au début de la période de tarification.

7. Contrôleur de maximum selon la revendication 5ou 6, caractérisé en ce que des périodes de temps pouvant être choisies ne sont pas prises en compte lors du calcul de la variation de valeur de consigne.

8. Contrôleur de maximum selon l'une des revendication 1 à 7, caractérisé en ce qu'une fréquence d'impulsions de mesure élevée par unité de travail (kWh), de préférence supérieure à 3000 impulsions / kWh, est prévue pour la détermination de la puissance momentanée et une limitation de puissance momentanée.

9. Contrôleur de maximum selon la revendication 8, caractérisé en ce que la limitation de puissance momentanée est liée aux consommateurs de seuils intégraux prédéterminables.

10. Contrôleur de maximum selon la revendication 9, caractérisé en ce qu'un retard de connexion et de déconnexion d'environ 50 milli-secondes est donné lors de la déconnexion par la limitation de puissance momentanée.

11. Contrôleur de maximum selon l'une des revendications précédentes, caractérisé en ce que les seuils intégraux et les seuils de tendance sont associés, les uns suivants aux autres dans le temps, à des seuils de rotation différents, qui se déroulent successivement.

12. Contrôleur de maximum selon l'une des revendications précédentes, caractérisé en ce que la valeur de passage au dessus, le plus grand possible, des seuils intégraux, peut être corrigée et est déterminée selon la formule suivante :

$$\text{Valeur de passage au dessus (kW)} = \frac{\text{Puissance pouvant être déconnecté (kW)}}{15 \times \text{temps de déconnexion (Min)}}$$

13. Contrôleur de maximum selon l'une des revendications précédentes, caractérisé en ce que une ligne coaxiale est prévue entre la centrale 24, des modules de sortie (AM) et des modules d'entrée (EM) pour l'échange de données.

14. Contrôleur de maximum selon la revendication 13, caractérise en ce que pour la réception des signaux arrivants par le câble coaxiale est prévu un montage de réception dans lequel le signal de données est découplé du câble coaxiale, par une résistance R1, de façon hautement ohmique, un amplificateur opérationnel est maintenu dans une position de sortie définie par un offset, la sortie OP est commutée après des dépassements de la tension offset et, après l'atteinte de la tension de passage d'une diode D1, le condensateur C1 est chargé par l'intermédiaire d'une résistance R1, comme condensateur entraîneur, de façon qu'après la fin de l'impulsion de données la charge soit maintenue par le condensateur C1 et l'OP soit recommuté dans la position de repos.

Fig.1

Fig. 2

Fig. 3

## Fig. 4

## Fig. 5

## Fig.6

Koax

R1

R2  D1  D2  IC1  +24V  R3  zur CPU(RXD)

C1  ZD1  R4

## Fig.7

von der CPU(TXD)  R1  T1  VCC  R2  T2  R3  R4  +24V  +24V  T3  R5  Koax

# Fig.8

Koax-Leitungszug
mit Wellenwiderstand Z

# Fig.9

TX a

Koax b

RX c

Koax d

RX e

Koax f

RX g

Koax h

RX i

16

# Fig.11